(19) Europäisches Patentamt
European Patent Office
Office européen des brevets

(11) **EP 4 691 664 A1**

(12) **EUROPEAN PATENT APPLICATION**
published in accordance with Art. 153(4) EPC

(43) Date of publication:
**11.02.2026 Bulletin 2026/07**

(21) Application number: 24780737.3

(22) Date of filing: **28.03.2024**

(51) International Patent Classification (IPC):
**B21J 5/00** (2006.01)     **B21B 1/22** (2006.01)
**B21B 3/00** (2006.01)     **B21B 37/00** (2006.01)

(52) Cooperative Patent Classification (CPC):
**B21B 1/22; B21B 3/00; B21B 37/00; B21J 5/00**

(86) International application number:
**PCT/JP2024/012881**

(87) International publication number:
**WO 2024/204639 (03.10.2024 Gazette 2024/40)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **30.03.2023   JP 2023055293**
                **26.09.2023   JP 2023164006**

(71) Applicant: **Proterial, Ltd.**
**Tokyo 135-0061 (JP)**

(72) Inventor: **TAKAGI, Kosuke**
**Tokyo 135-0061 (JP)**

(74) Representative: **Cabinet Beaumont**
**4, Place Robert Schuman**
**B.P. 1529**
**38025 Grenoble Cedex 1 (FR)**

(54) **HOT-WORKING CONDITION PREDICTION METHOD AND PROGRAM**

(57)     The object of the present invention is to provide a prediction method capable of highly accurately predicting a hot working condition under which cracks occur and suppressing the occurrence of cracks in actual hot working.

Provided is a prediction method for a hot working condition for predicting a hot working condition of a material subjected to hot working having a decarburization layer on a surface layer, comprising: a hot working property acquisition process of acquiring a hot working property at a part of a two-phase region of ferrite + austenite in the decarburization layer formed on the surface layer of the material subjected to hot working; a first analysis process of performing a plastic deformation analysis by simulation using the acquired hot working property as an input value and deriving a fracture threshold; a second analysis process of performing a plastic working analysis by simulation simulating actual hot working and deriving a fracture parameter corresponding to an amount of deformation of a material subjected to hot working; and a working condition derivation process of deriving a working condition threshold at a time of performing hot working in an actual machine based on the fracture threshold and the fracture parameter.

FIG.1

## Description

### Technical Field

The present invention relates to a prediction method for a hot working condition and a program thereof.

### Background Art

Hot forging known as a working method for steel has traditionally had a problem of cracking defects occurring in a forged steel piece or steel material. When such cracks are formed, defect removal processes such as surface grinding and truncation have to be performed in order to repair defects, which leads to reduction in yield and increase in costs. One cause of cracks that occurs during forging is that an amount of deformation exceeding the hot working property of a material subjected to hot working is applied during hot working. Materials generally have different susceptibilities to cracking, and even for the same material, the occurrence or non-occurrence of cracking may differ depending on the heating temperature and the cooling temperature during the forging process. In order to effectively suppress such forging cracks, a working condition under which cracks may occur is predicted in advance and an appropriate working condition is set.

A commonly known prediction method for cracks is calculating an index to evaluate a fracture by Finite Element Method and comparing the index with a threshold. For example, Patent Literature 1 discloses a prediction method in which a fracture parameter of the material to be forged in free hot forging is obtained by performing a thermal-mechanical coupled deformation analysis of a material to be forged and applying a fracture criterion formula to the stress and strain obtained from the analysis. Then, the fracture parameter is compared with a fracture threshold to predict the occurrence of cracks in the material to be forged. The applicant of the present application proposes, in Patent Literature 2, a fracture prediction method in which an inherent fracture threshold of a workpiece as a target of plastic working is specified, and the inherent fracture threshold is compared with a fracture effect accumulated based on the working temperature and strain rate during plastic working, and the presence or absence of a fracture occurring in the workpiece during the plastic working is determined and the location of the fracture is predicted. Citation List

### Prior Art Documents

> [Patent Literature 1] Japanese Patent Application Laid-Open Publication No. 2010-131621
> [Patent Literature 2] Japanese Patent Application Laid-Open Publication No. 2022-41548

### Summary of the Invention

### Problems to be Solved by the Invention

While Patent Literature 1 and Patent Literature 2 disclose the inventions useful for predicting occurrence of a fracture in a workpiece, hot working property inside the materials is obtained by a high-temperature tensile test in Patent Literature 1 and Patent Literature 2. Cracks occur on the surface layer of a material in an actual manufacturing process, and thus setting a forging condition considering the surface microstructure, which can be the starting points of cracks, helps predict a surface crack during forging with higher accuracy, and there is thus still much left to be improved.

Hence, the object of the present invention is to provide a prediction method capable of highly accurately predicting a hot working condition under which cracks occur and suppressing the occurrence of cracks in actual hot working.

### Means for Solving the Problems

The present invention is made in view of the above-described problems.

That is, the present invention is a prediction method for a hot working condition for predicting a hot working condition of a material subjected to hot working having a decarburization layer on a surface layer, comprising: a hot working property acquisition process of acquiring a hot working property at a part of a two-phase region of ferrite + austenite in the decarburization layer formed on the surface layer of the material subjected to hot working; a first analysis process of performing a plastic deformation analysis by simulation using the acquired hot working property as an input value and deriving a fracture threshold; a second analysis process of performing a plastic working analysis by simulation simulating actual hot working and deriving a fracture parameter corresponding to an amount of deformation of a material subjected to hot working; and a working condition derivation process of deriving a working condition threshold at a time of performing hot working in an actual machine based on the fracture threshold and the fracture parameter. Advantageous Effects of the Invention

According to the present invention, it is possible to highly accurately predict a hot working condition under which cracks occur and suppress the occurrence of cracks in actual hot working.

Brief Description of the Drawings

FIG. 1 is a photograph illustrating a crack that occurs in a steel material after hot working.
FIG. 2 is a flowchart illustrating a flow of a prediction method of the present invention.
FIG. 3 illustrates the shape of a tensile test piece.
FIG. 4 illustrates an analytical model of plastic working simulation.
FIG. 5 is a graph indicating a relationship between a fracture parameter D and amount of reduction calculated from the plastic working simulation.
FIG. 6 is a graph representing a surface temperature and a working condition threshold.
FIG. 7 illustrates the configuration of a working condition prediction system.
FIG. 8 illustrates a diagram showing the sampling location of the test pieces.
FIG. 9 is an example of the result of a plastic deformation analysis.
FIG. 10 illustrates a prediction method for a working condition.
FIG. 11 is a flowchart illustrating a flow of the processing of a program.
FIG. 12 is a flowchart illustrating a flow of the subroutine processing for working condition estimation.
FIG. 13 illustrates a simulation result of hot working in a modification example.
FIG. 14 is an example of a graph plotting data extracted from FIG. 13where the amount of reduction is 150 mm.

Description of the Invention

[Embodiment 1]

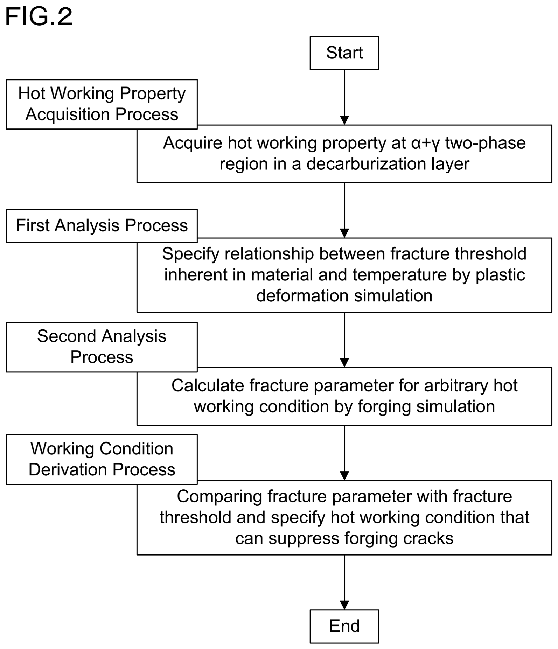

The present invention is described in detail below. The present invention is not limited to the contents of the embodiment described herein, and can approximately be combined and improved as necessary within the scope of technical idea of the present invention. FIG. 2 illustrates a flowchart of a prediction method of the present invention.

The present invention is preferably applied especially to the types of steel, among carbon steels and alloy steels, the surface layer of which becomes a two-phase microstructure of ferrite + austenite due to decarbonization when heated in air at atmospheric pressure to a hot working temperature of 700°C to 1200°C, with the matrix microstructure being in the austenite phase. Examples of such steel include hot work tool steels typified by SKD61 or the like. Hot working methods include hot forging such as free forging and mold forging as well as hot rolling. In the present embodiment, an SKD61 improved material is selected as a material subjected to hot working, and hot free forging is selected as a hot working method.

<Hot Working Property Acquisition Process>

First, in the present embodiment, a hot working property is acquired at a two-phase region of ferrite + austenite in a decarburization layer formed on the surface layer of a material subjected to hot working (hot working property acquisition process). Material subjected to hot working includes a steel ingot produced by casting and a steel piece (slab, bloom, billet) obtained by subjecting a steel ingot to blooming. The material subjected to hot working of the present embodiment employs a steel piece.

The "hot working property" acquired in the present embodiment indicates a tensile property (high-temperature tensile property) of a material subjected to hot working obtained under a hot working condition (e.g., 700°C to 1200°C for SKD61). Specifically, ductility under a high-temperature condition, i.e., elongation after fracture and reduction-of-area characteristic, is obtained using test pieces sampled from the surface layer of the material subjected to hot working. Alternatively, the amount of displacement (fracture displacement) of a test piece at the time of being fractured during a tensile test may be obtained as a high-temperature tensile property. The test piece may be a tensile test piece with a prism-shaped parallel part or a plate-shaped parallel part. Here, the tensile property of a material subjected to hot working fluctuates depending on a hot-working temperature and a reduction speed, and thus multiple tensile properties are preferably acquired under various conditions of test temperature and strain rate. In addition, a cylindrical compression test piece may be used for acquiring a deformation resistance, which is one of the hot working properties, and multiple deformation resistances may be acquired under various conditions of test temperature and strain rate. This makes it possible to derive a working condition threshold that takes working temperatures and reduction speeds into consideration in a working condition derivation process to be described later of the present invention. The present embodiment employs high-frequency induction heating as a heating mechanism for a test piece, but may also employ electric heating. The above-mentioned high-temperature tensile property may be acquired using a simulation or the like other than the above-mentioned measurement. The "surface layer" according to the present invention refers to a depth from the surface of the material subjected to hot working to the thickness of the material subjected to hot working x 0. 1. In addition, the term "decarburization layer" according to the present invention refers to a depth from the surface of a material subjected to hot working to a depth where the carbon content of the base microstructure is 95% or less based on JIS G0558.

In the hot working property acquisition process according to the present embodiment, the hot working property is acquired by especially focusing on the two-phase region of ferrite + austenite in the decarburization layer. This is a primary feature of the present invention (hereinafter, the ferrite phase being referred to as an $\alpha$ phase, the austenite phase being referred to as a $\gamma$ phase, and the two-phases region of ferrite + austenite being referred to as an $\alpha + \gamma$ phase). Especially, when carbon steel and alloy steel especially are heated to a hot working temperature of 700°C to 1200°C in the atmosphere, an $\alpha+\gamma$ phase region may sometimes be formed on the surface layer because the carbon content of the surface layer decreases due to decarbonization. Since the above-mentioned $\alpha + \gamma$ phase tends to have lower hot workability than that of the $\gamma$ phase, the prediction accuracy of a hot working crack may be lower in the case where a fracture threshold to be described later is derived using the hot working properties acquired in the high-temperature tensile test performed on the homogeneous microstructure inside the material. In the present embodiment, a hot working property thus needs to be acquired targeting on the $\alpha+\gamma$ phase region at the decarbonization layer on the surface layer of the steel piece.

Here, in order to acquire a carbon concentration profile from the decarbonization layer on the surface layer of the steel piece, the number of carbons may be measured from the cross section of the test piece cut from the surface layer of the steel piece with an electron probe microanalyzer (EPMA), and the number of carbons may be converted into carbon concentration by a calibration curve prepared using a carbon steel with a known carbon concentration. In order to identify the phase compositions of the $\alpha$ phase, the $\gamma$ phase and the $\alpha+\gamma$ phase, after quenching treatment of the test piece cut from the surface layer of the steel piece, the cross-section of the decarbonization layer can be checked for identification based on the presence or absence of martensitic transformation in the microstructure.

<First Analysis Process>

Next, in the present embodiment, a plastic deformation analysis is performed by simulation using hot working properties as input values to derive a fracture threshold (first analysis process). The simulation may employ a rigid plastic analysis or an elastoplastic analysis. The plastic deformation analysis is implemented to evaluate temperature dependency of the fracture threshold at the $\alpha+\gamma$ phase region. In the present embodiment, the fracture threshold is evaluated as a function of the temperature. Other than the temperature, strain rate dependency, for example, may be used. In the plastic deformation analysis, under the same test condition as that used in the hot working property acquisition process, the maximum principal stress $\sigma\_max\_f$, von Mises stress $\sigma\_eff\_f$ and equivalent plastic strain $\varepsilon\_f$ in the ruptured portion are specified at the time when the elongation after fracture, reduction-of-area or fracture displacement in the plastic deformation analysis become the same values as the elongation after fracture, reduction-of-area or fracture displacement of the test piece in the hot working process, to evaluate a fracture threshold $D\_f$ by the normalized Cockroft and Latham formula expressed by formula (1). Another commonly proposed fracture criterion formula, such as Oyane's formula, may be used to determine a fracture condition.

[Formula 1]

$$D_f = \int_0^{\varepsilon_f} \left( \frac{\sigma_{max\_f}}{\sigma_{eff\_f}} \right) d\varepsilon \qquad \text{formula (1)}$$

<Second Analysis Process>

Next, plastic working analysis simulating actual hot working is performed by simulation to derive a fracture parameter corresponding to the amount of deformation of material subjected to hot working (second analysis process). The "fracture parameter corresponding to the amount of deformation" is the parameter D calculated by formula (2) using, as variables, the maximum principal stress ($\sigma\_max$, von Mises stress $\sigma\_eff$ and equivalent plastic strain $\varepsilon$ that occur when working is performed at any processing amount in Finite Element Method based on the rigid or elastoplastic analysis.

[Formula 2]

$$D = \int \left( \frac{\sigma_{max}}{\sigma_{eff}} \right) d\varepsilon \qquad \text{formula (2)}$$

In the plastic working analysis, the shapes of a material subjected to hot working and a die are first imported as models into the analysis software. Then, the deformation resistance and thermophysical property of the material subjected to hot working are imported into the model of the material subjected to hot working. The deformation resistance is preferably acquired from the material subjected to hot working. More preferably, considering that a decarbonization layer is formed on the surface layer of the material subjected to hot working, an element simulating the decarbonization layer is set on the surface layer of the model, and a deformation resistance obtained from the decarbonization layer of the material subjected to hot working is applied to the element of the decarbonization layer. A hot working condition is then input to the analysis software. In the case of hot forging, for example, a heating temperature of a material to be forged, a time from when the material to be forged is removed from a furnace to when it is placed on a forging press, a reduction speed and an amount of reduction during forging, and the like as a working condition are input to the analysis software. Then, regarding a process of applying pressure to the material to be forged in uniform thickness from the leading edge to the trailing edge in the longitudinal direction thereof as one pass, a fracture parameter D for the aforementioned one pass is derived. The shapes of models of the material subjected to hot working and the die used for the plastic working analysis of the present embodiment are not particularly limited. In the present embodiment, for example, the initial shape of a material to be forged may employ a quarter model of a prism shape, but may be the model in the shape of a prism or one-half of the prism, or may be a cylindrical shape.

<Working Condition Derivation Process>

In the present embodiment, based on the fracture threshold and the fracture parameter respectively obtained in the first and second analysis processes, a working condition threshold during hot working for the actual machine is derived (working condition derivation process). In other words, the fracture threshold at the $\alpha+\gamma$ phase region is compared with the fracture parameter at the $\alpha+\gamma$ phase region to determine an amount of reduction (working condition threshold) at which the fracture parameter is equal to or less than the fracture threshold at any working temperature or reduction speed. A working temperature can also be evaluated as a working condition threshold such that the fracture parameter at an arbitrary amount of reduction and reduction speed that is obtained in the second analysis process is equal to or less than the fracture threshold obtained in the first analysis process. Likewise, an amount of reduction can be evaluated as a working condition threshold from an arbitrary amount of reduction and working temperature. Alternatively, the relationship between the amount of reduction and the working temperature as well as the relationship between the amount of reduction and the reduction speed are obtained as working condition thresholds in advance and are plotted in a three-dimensional graph, whereby a working condition threshold can be derived based on arbitrary two variables. In actual manufacturing, a working condition is set based on the derived working condition threshold to thereby suppress cracks during hot working.

[Examples]

(Example 1)

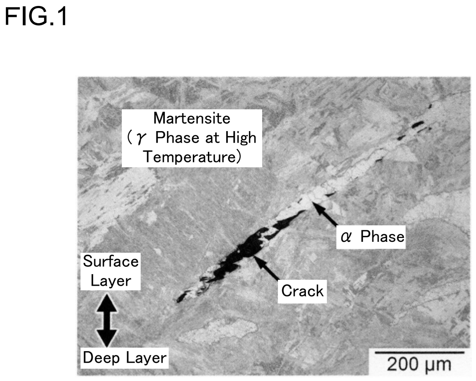

As a basic study before confirming the effect of the present invention, in order to find a crack causing microstructure during forging for the SKD61 improved material, the configuration of the surface microstructure and its hot working property were investigated. First, a hot working tensile test simulating hot forging was implemented on a test piece (dimension of the parallel part: $\varphi$ 8 mm) that is sampled so as to contain a decarbonization layer formed on the surface layer of the SKD61 improved material. FIG. 1 indicates the location of a crack occurring inside the test piece. FIG. 1 illustrates that a large crack occurs at the interface between the $\alpha$ and $\gamma$ phases in the $\alpha + \gamma$ phase region at the decarbonization layer of the SKD61 improved material, which indicates that the $\alpha+\gamma$ phase region has lower hot working properties than that in the $\gamma$ phase that is not decarbonized. It is confirmed that the crack causing microstructure for the SKD61 improved material is highly likely the $\alpha+\gamma$ phase region formed at the decarbonization layer on the surface layer of the steel piece.

(Example 2)

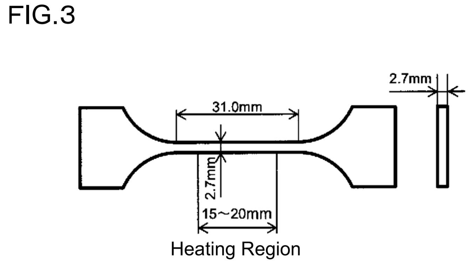

Next, tests to confirm the effect of the present invention were performed. First, as a hot working property acquisition process, tensile test pieces illustrated in FIG. 3 were sampled from the locations different in depths from the surface layer of the steel piece of the SKD61 improved material with the $\alpha+\gamma$ phase region formed on its surface layer. The temperature was raised from room temperature to 1100°C and held for 2 hours at 1100°C. After decreasing temperature in decrements of -0.1°C/s down to the test temperature so as to be held at each temperature for 5 minutes, a tension test was performed on the test piece at a crosshead speed of 1. 5 mm/s assuming an average strain rate for press forging. After the test piece is fractured, the configuration of the microstructure during the test was identified by observing the longitudinal cross section of the parallel part of the test piece. Table 1 depicts a fracture displacement obtained when the $\alpha$ single phase, the $\alpha+\gamma$ phase and the $\gamma$ single phase at the decarbonization layer of the SKD61 improved material are heated up to 900°C. Table 1 indicates that the ductility at the $\alpha+\gamma$ phase region is clearly reduced in comparison with the $\alpha$ single phase and the $\gamma$ single phase.

[Table 1]

|  | $\alpha$ single phase | $\gamma$ single phase | $\alpha+\gamma$ two phase |
|---|---|---|---|
| Fracture displacement | 9.1 mm | 9.1 mm | 6.5 mm |

As a first analysis process, in order to derive a fracture threshold from the hot working properties obtained in the aforementioned hot working property acquisition process, analysis was performed on the decarbonization layer of a material subjected to hot working using commercially available plastic deformation simulation software, taking the deformation resistances at the temperature range of 700°C to 1200°C and the strain rate range of 0.01/s to 1.0/s into consideration. The details of the analysis include deforming, in simulation, the test piece up to the obtained fracture displacement for the $\alpha+\gamma$ phase region, specifying the maximum principal stress $\sigma\_max\_f$, von Mises stress $\sigma\_eff\_f$ and equivalent plastic strain $\varepsilon\_f$ in the displacement of the test piece at a time of fracture, and evaluating a fracture threshold Df by the normalized Cockroft and Latham formula.

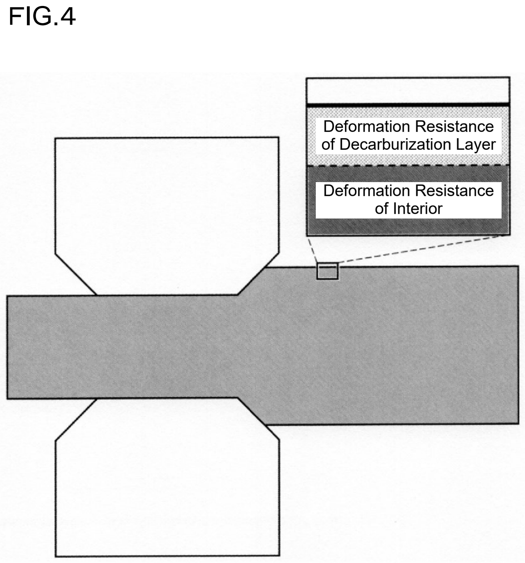

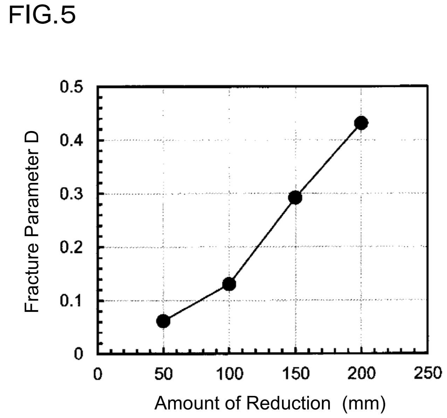

As a second analysis process, a plastic working analysis is performed by forging, in simulation, a prism-shaped material subjected to hot working with truncated-conical anvils illustrated in FIG. 4 to derive a fracture parameter D corresponding to the amount of deformation of the material subjected to hot working. Using a commercially available forging simulation software, forging analyses were performed for only one pass at various amount of reductions to read the maximum value of the fracture parameter D that is calculated regarding the maximum principal stress $\sigma\_max$, equivalent stress of Mises $\sigma\_eff$ and equivalent plastic strain $\varepsilon$ generated on the surface as variables. Here, the transition of the surface temperature when a material subjected to hot working with any cross-sectional area is allowed to air-cool from an arbitrary heating temperature is evaluated by the heat transfer analysis. FIG. 5 depicts the relationship between the obtained fracture parameter D and the amount of reduction. FIG. 5 indicates that the fracture parameter D increases linearly relative to the r amount of reduction.

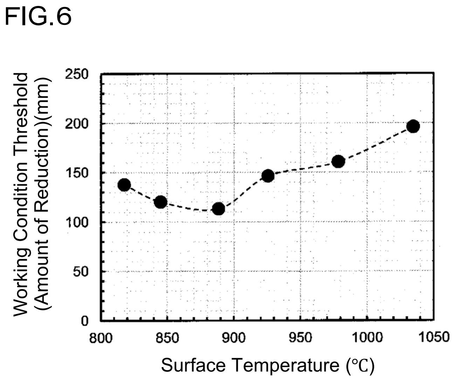

As a working condition derivation process, from the fracture threshold for the $\alpha+\gamma$ region obtained in the first analysis process and the relationship between the fracture parameter D and the amount of reduction obtained in the second analysis process, an amount of reduction, i.e., a working condition threshold at which the fracture parameter D is equal to or less than the above-mentioned fracture threshold was evaluated. FIG. 6 depicts the relationship between the surface temperature and the above-mentioned working condition threshold. By performing forging with the amount of reduction smaller than the above-mentioned working condition threshold indicated by the dashed line in FIG. 6, e.g., the amount of reduction less than 100 mm, a crack can be found to be suppressed at the $\alpha+\gamma$ phase region on the surface of the material subjected to hot working.

(Example 3)

Under the condition of the amount of reduction less than 100 mm, which is the working condition threshold obtained in Example 2, hot working (hot forging) was actually performed, and the effect thereof was confirmed. Two steel ingots (about 10 tons) of SKD61 improved material were prepared, and hot forging was performed on the ingots at a working temperature of 800°C to 1050°C to obtain hot-worked materials with a cross-sectional area of about 500, 000 mm$^2$. The hot-worked material in the example of the present invention underwent hot-working so that the amount of reduction per one pass is 100 mm or less, while the hot-worked material in the comparative example underwent hot working so that the amount of reduction exceeds 100 mm at a part of the pass of hot working. Then, a penetrant test in accordance with JIS Z2343 was performed on the longitudinal cross section of the obtained hot-worked materials in the example of the present invention and the comparative example to measure the density of internal cracks (cracks caused by the $\alpha+\gamma$ phase region formed at the decarbonization layer). As a result, 30 internal cracks per one meter were observed for the sample in the comparative example, while 14 internal cracks per one meter were observed for the sample in the example of the present invention. It is thus apparent that the number of internal cracks occurring in the example of the present invention is reduced by half compared to that in the comparative example, and thus the working condition threshold (amount of reduction) derived by the prediction method according to the present invention also exerts an effect in actual manufacturing.

[Embodiment 2]

The present embodiment relates to hardware and software used for predicting a hot working condition. Parts that are common to those of Embodiment 1 will not be described.

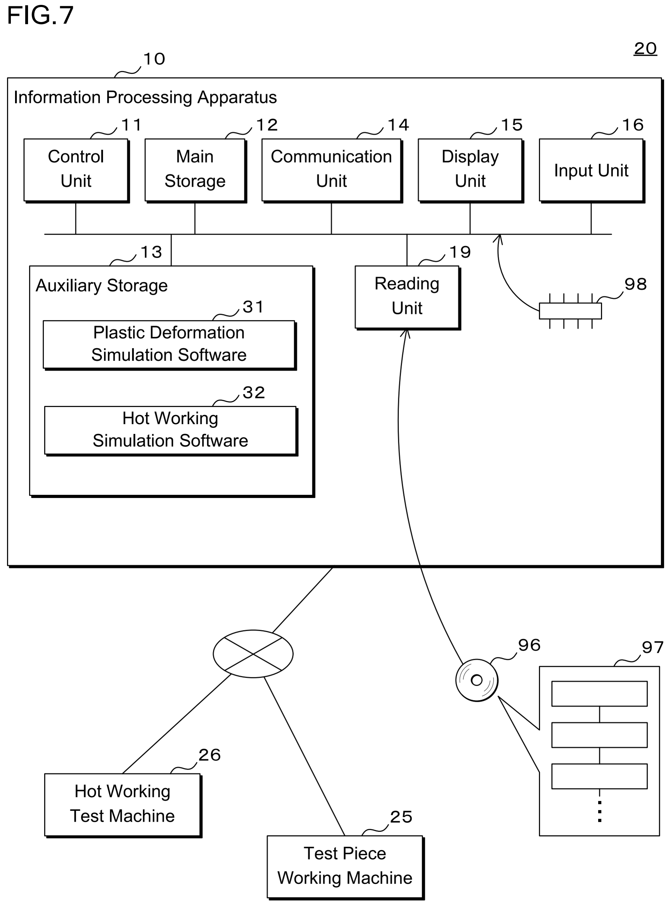

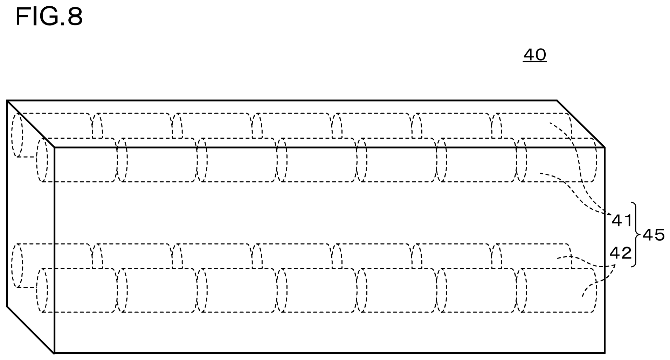

FIG. 7 illustrates the configuration of a working condition prediction system 20. The working condition prediction system 20 is provided with an information processing apparatus 10, a test piece working machine 25 and a hot working tester 26 that are connected through networks. The test piece working machine 25 is a machine tool that works a sample 40 (see FIG. 8) to produce a test piece with a predetermined shape. The test piece has a shape illustrated in FIG. 3, for example.

In the following description, a case where the sample 40 is a steel ingot or a steel piece, or a part cut out from a steel ingot or a steel piece will be described below by way of example.

The test piece working machine 25 may be constructed such that several automatic working machines connected by a conveyor device (not illustrated) are combined. Devices for working a material into a given shape have already been known, so that details thereof are not described. The test piece working machine 25 may be a general-purpose working machine operated manually or semi-automatically by a professional technician.

The hot working tester 26 is a tester capable of being used for tensile tests in accordance with JIS G0567: 2020 (Japanese Industrial Standard / Method of elevated temperature tensile test for steels and heat-resisting alloys). Since standard-compliant testers have been well known, the details thereof are not described.

A test piece 45 (see FIG. 8) is removed from the test piece working machine 25 by a conveyor robot (not illustrated) or the like and installed on the hot working tester 26. The test piece 45 was tested with the aforementioned hot working tester 26. Removal of the test piece 45 from the test piece working machine 25, transfer of the test piece 45 from the test piece working machine 25 to the hot working tester 26 and installation of the test piece 45 to the hot working tester 26 may be performed manually or semi-automatically.

The information processing apparatus 10 is provided with a control unit 11, a main storage 12, an auxiliary storage 13, a communication unit 14, a display unit 15, an input unit 16, a reading unit 19 and a bus.

The control unit 11 is an arithmetic control device that executes a program according to the present embodiment. One or more CPUs (Central Processing Units), GPUs (Graphics Processing Units), multi-core CPUs or the like are used. The control unit 11 is connected to each of the hardware components constituting the information processing apparatus 10 via the bus.

The main storage 12 is a storage device such as an SRAM (Static Random Access Memory), a DRAM (Dynamic Random Access Memory) and a flash memory. The main storage 12 temporarily stores information necessary during the processing performed by the control unit 11 and a program that is being executed by the control unit 11.

The auxiliary storage 13 is a storage device such as an SRAM, a flash memory, a hard disk or a magnetic tape. The auxiliary storage 13 stores software such as plastic deformation simulation software 31, hot working simulation software 32 and a program that is to be executed by the control unit 11, as well as various data necessary for the execution of the respective software.

The communication unit 14 is an interface for communication between the information processing apparatus 10 and the network. The display unit 15 is, for example, a liquid crystal display panel or an organic EL (Electro-Luminescence) panel. The input unit 16 is an input device such as a keyboard, a mouse, a microphone or the like. The display unit 15 and the input unit 16 may be stacked to form a touch panel.

A portable recording medium 96 corresponds to, for example, a USB (Universal Serial Bus) memory, a CD-ROM (Compact Disc Read Only Memory), a magneto-optical disk medium, other optical disk media or an SD memory card. The portable recording medium 96 stores a program 97 to be described later.

The reading unit 19 is an interface that can be connected to the portable recording medium 96, such as a USB connector, a CD-ROM drive, an SD memory reader or the like. A semiconductor memory 98 stores the program 97 and is a memory that is attachable to the inside of the information processing apparatus 10.

The information processing apparatus 10 is a general-purpose personal computer, a tablet, a large computer, a virtual machine running on a large computer or a quantum computer. The information processing apparatus 10 may be configured by hardware such as multiple personal computers that perform distributed processing, a large computer or the like. The information processing apparatus 10 may be configured by a cloud computing system. The information processing apparatus 10 may be composed by hardware such as multiple personal computers operating in cooperation with each other, a large computer or the like.

The program 97 is recorded onto the portable recording medium 96. The control unit 11 reads the program 97 through the reading unit 19 and stores it in the auxiliary storage 13. The control unit 11 may further read the program 97 stored in the semiconductor memory 98. The control unit 11 may further download the program 97 from other server computers (not illustrated) connected through the communication unit 14 and the network (not illustrated) and stores it into the auxiliary storage 13.

The program 97 is installed as a control program of the information processing apparatus 10 and loaded into the main storage 12 for execution. The program 97 according to the present embodiment is an example of a program product.

The plastic deformation simulation software 31 is a software that simulates the behavior of plastic deformation when stress is applied to a material by using numerical analysis methods such as Finite Element Analysis. The hot working simulation software 32 is software that simulates the behavior of plastic deformation occurring on a material subjected to hot working during hot working such as forging in which pressure is applied to a material placed on an anvil, by using numerical analysis methods such as Finite Element Analysis.

Since both of the plastic deformation simulation software 31 and the hot working simulation software 32 have already been known, detailed processing will not be described. The information input to and output from the simulation software will be described later.

The plastic deformation simulation software 31 and the hot working simulation software 32 may be provided in the form of SaaS (Software as a Service) by a large computer connected to the information processing apparatus 10 via a network, or cloud services.

The outline of the processing to be performed in the present embodiment is first described.

[Test Piece Production]

FIG. 8 illustrates a diagram showing the sampling location of the test pieces 45. As described above, a case where the sample 40 is a steel ingot or a steel piece will be described by way of example. FIG. 8 schematically illustrates the sample 40 cut into a rectangular parallelepiped. A decarbonization layer is formed near the upper surface of the sample in FIG. 8. The decarbonization layer contains a part where a two-phase region of ferrite + austenite is formed. Which portion of the sample 40 is in the two-phase region can be detected by observing the cross section of the sample 40 using EPMA or the like as described above.

The control unit 11 controls the test piece working machine 25 to produce multiple two-phase region test pieces 41 from the part of the two-phase region. The control unit 11 controls the test piece working machine 25 to produce multiple non-decarburization layer test pieces 42 from a non-decarburization layer that is present deeper than the decarbonization layer. Note that production of the test piece 45 may be performed by a professional technician operating the test piece working machine 25. In the following description, the two-phase region test piece 41 and the non-decarburization layer test piece 42 may sometimes simply be referred to as the test piece 45 if they do not need to be discriminated from each other.

Though the test piece 45 is simply illustrated to be cylindrical in FIG. 8, it takes the shape of the tensile test piece illustrated in FIG. 3. The test piece 45 may be of the shapes specified in Annex A of JIS G0567: 2000, or Annex B to E of JIS Z2241: 2022 (Japanese Industrial Standard/Metallic materials-Tensile testing-Method of test at room temperature). Note that a deformation resistance and a fracture displacement $\delta f$ to be described later may be obtained separately, and for the acquisition of the deformation resistance, the test piece 45 may be a cylindrical compression test piece.

[Data Collection]

The control unit 11 can control the hot working tester 26 to measure a deformation resistance and a fracture displacement $\delta f$ for the test piece 45. The measurement may be performed by an expert technician operating the hot working tester 26, and the measurement data may be transmitted to the information processing apparatus 10.

The control unit 11 controls the hot working tester 26 to measure deformation resistances and fracture displacements $\delta f$ in multiple combinations of strain rates and temperatures for the two-phase region test pieces 41 and the non-decarburization layer test pieces 42. The strain rates to be used include, for example, 0. 01/s and 1/s in addition to 0.1/s. The temperatures to be used include, for example, 700°C to 1100°C in 100°C increments. In addition, a combination of an arbitrary temperature and an arbitrary strain rate may be used.

The acquisition process for the fracture displacement $\delta f$ of the two-phase region test piece 41 using the hot working tester 26 is one example of the hot working property acquisition process.

The control unit 11 controls various measurement devices (not illustrated) to measure elastic properties such as Young's modulus and Poisson's ratio, and thermal properties such as temperature dependency of a thermal expansion rate and temperature dependency of thermal conductivity. These measurements may also be performed by professional technicians.

For data other than the data on the deformation resistance and the fracture displacement $\delta f$, data measured using either the two-phase region test pieces 41 or the non-decarburization layer test pieces 42 may be used as representative values. Data other than the data on the deformation resistance and the fracture displacement $\delta f$ may be data measured using existing steel materials with similar properties. The deformation resistance of the test piece 45 may be obtained using simulations instead of actual measurements.

[Plastic Deformation Simulation]

Table 2 depicts input data to be input to the plastic deformation simulation software 31.

[Table 2]

| Item | | Remarks |
|---|---|---|
| Deformation resistance for two-phase region | | actual measured value for each combination of temperature and strain rate |
| Young's modulus | | |
| Poisson's ratio | | |
| Temperature dependency of thermal conductivity | | thermal conductivity at each temperature |
| Temperature dependency of thermal expansion rate | | thermal expansion rate at each temperature |
| Simulation conditions | | |
| | Temperature T | |
| | Strain rate | |
| | Fracture displacement δf | |
| | Shape of test piece model | The shape of test piece may be different from the shape of the test piece used to measure the deformation resistance and fracture displacement δf |

The control unit 11 inputs the data depicted in Table 2 to the plastic deformation simulation software 31. The plastic deformation simulation software 31 outputs various stresses and strains that occur inside the test piece model when both ends of the test piece model are separated by the fracture displacement δf. The control unit 11 calculates a fracture threshold $D\_f$ at a temperature T by formula (1). The control unit 11 calculates fracture thresholds $D\_f$ at the multiple temperatures T.

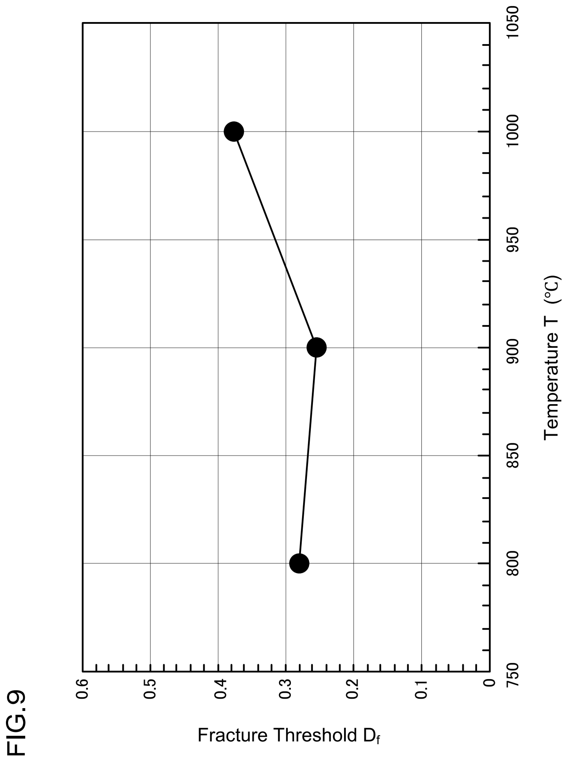

FIG. 9 is an example of the result of the plastic deformation analysis. The horizontal axis in FIG. 9 represents the temperature T in units of degrees Celsius. The vertical axis in FIG. 9 represents the fracture threshold D f. The fracture threshold $D\_f$ is a dimensionless quantity. In FIG. 9, the subscript f is used instead of" f."

The plastic deformation simulation software 31 is an example of the software that performs the plastic deformation analysis in simulation by using a hot working property as an input value. The process of using the plastic deformation simulation software 31 is an example of the first analysis process for deriving a fracture threshold $D\_f$.

[Hot working Simulation]

Table 3 depicts input data to be input to the hot working simulation software 32. Note that Young's modulus and Poisson's ratio of the die are measured in advance and stored in the auxiliary storage 13.

[Table 3]

| Items | Remarks |
|---|---|
| | |
| Deformation resistance for two-phase region | actual measured value for each combination of temperature and strain rate |

| Deformation resistance of non-decarburization layer | |
|---|---|
| Young's modulus | |
| Poisson's ratio | |
| Temperature dependency of thermal conductivity | thermal conductivity at each temperature |
| Temperature dependency of thermal expansion rate | thermal expansion rate at each temperature |
| Die | |
| Young's modulus | |
| Poisson's ratio | |
| Heat transfer coefficient between material subjected to hot working and die | |
| Shape of hot working model | Shape of die model and shape of material subjected to hot working (before hot working) The shape of material subjected to hot working includes the shape of the non-decarburization layer and the shape of the decarbonization layer including the two-phase region. |
| Hot Working Condition | |
| Heating temperature of material subjected to hot working | |
| Time until start of hot | Elapsed time after material subjected to hot |

| working | working was removed from the furnace |
|---|---|
| Temperature of die | |
| Reduction speed | |
| Amount of reduction | |
| Die travel distance for passes | |

The control unit 11 inputs the data depicted in Table 3 to the hot working simulation software 32. The hot working simulation software 32 outputs various stresses and strains that occur inside the model of a material subjected to hot working when the material subjected to hot working is worked for the parameters of the hot working condition. The control unit 11 calculates a fracture parameter D based on formula (2). The control unit 11 calculates fracture parameters D at multiple amount of reductions. FIG. 5 above is an example of the calculation results.

The hot working simulation software 32 is an example of software that performs plastic working analysis simulating actual hot working. The process using the hot working simulation software 32 is an example of the second analysis process for deriving the fracture parameter D.

[Prediction of Hot Working Condition]

A case where the target temperature at the completion of the hot working is 900°C will be described by way of example. The control unit 11 evaluates a fracture threshold D_f at a temperature of 900°C based on the analysis results of the plastic deformation described with reference to FIG. 9. In the example depicted in FIG. 9, the fracture threshold D_f at 900°C is approximately 0.25.

Assuming that the plastic deformation analysis at a desired temperature has not been performed, the control unit 11 newly executes plastic deformation analysis at the desired temperature to calculate a fracture threshold D_f, or uses an arbitrary interpolation method to determine a fracture threshold D_f at the desired temperature.

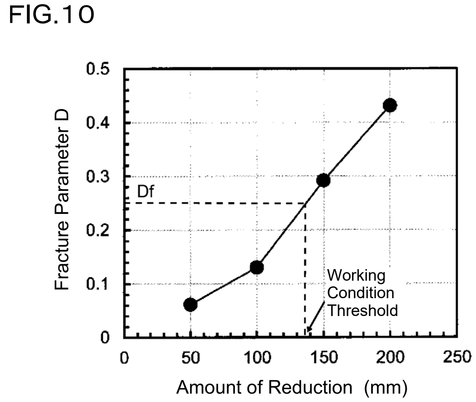

FIG. 10 illustrates a prediction method for a working condition. FIG. 10 is a graph corresponding to FIG. 5 with a dotted auxiliary line added. The horizontal axis in FIG. 10 represents an amount of reduction in hot working in units of mm. The vertical axis in FIG. 10 represents the fracture parameter D. The fracture parameter D is dimensionless.

The control unit 11 calculates an amount of reduction when the fracture parameter D is 0.25 of the fracture threshold based on the relation between the amount of reduction and the fracture parameter D illustrated in FIG. 5 and FIG. 10. The calculated amount of reduction is the maximum amount of reduction under which no cracks occur in the material subjected to hot working, that is, a threshold of the working condition. The process to calculate an amount of reduction when the fracture parameter D is equal to the value of the fracture threshold D_f is an example of the working condition derivation process for deriving the working condition threshold during hot working on an actual machine.

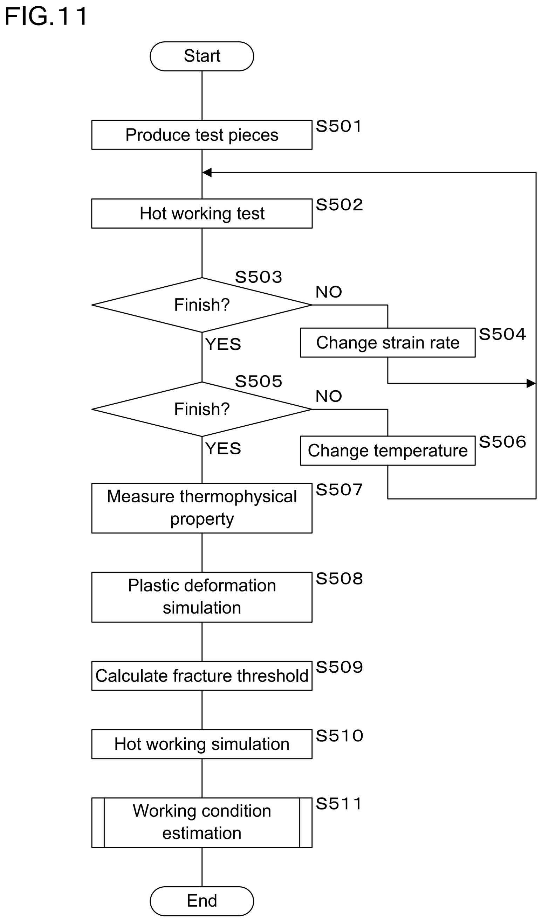

FIG. 11 is a flowchart illustrating a flow of the processing of the program. FIG. 11 is used to describe the flow of the processing of the program when the control unit 11 automatically executes all the processes.

The control unit 11 controls the test piece working machine 25 to produce multiple test pieces 45 (step S501). The control unit 11 controls the conveyor robot or the like to install the test piece 45 on the hot working tester 26. The control unit 11 controls the hot working tester 26 to perform a hot working test at a predetermined temperature and a predetermined strain rate (step S502). The hot working tester 26 measures and records the deformation resistance and the fracture displacement δf.

The control unit 11 determines whether or not the test at a predetermined strain rate has been finished (step S503). If determining that the test at the predetermined strain rate has not been finished (NO at step S503), the control unit 11 changes the strain rate to be tested (step S504). Note that the list of strain rates at which tests are conducted is stored in advance in the auxiliary storage 13. The control unit 11 returns the processing to step S502.

If it is determined that the test at the predetermined strain rate has been finished (YES at step S503), the control unit 11 determines whether or not a test at a predetermined temperature has been finished (step S505). Note that the list of test temperatures at which the tests are conducted is stored in advance in the auxiliary storage 13. If determining that the test at the predetermined temperature has not been finished (NO at step S505), the control unit 11 changes the test temperature (step S506). The control unit 11 returns the processing to step S502.

If determining that the test at the predetermined temperature has been finished (YES at step S505), the control unit 11 controls various measurement devices to measure thermophysical properties of the test piece 45 (step S507). The control unit 11 inputs the deformation resistance and the fracture displacement δf measured at step S502 and the thermophysical properties measured at step S507 to the plastic deformation simulation software 31 to implement a plastic deformation simulation (step S508). The control unit 11 substitutes data output from the plastic deformation simulation software 31 into formula (1) to calculate a fracture threshold D_f at a temperature T (step S509).

The control unit 11 inputs the deformation resistance and the fracture displacement δf measured at step S502 and the thermophysical properties measured at step S507 to the hot working simulation software 32 to implement a hot working simulation (step S510). The control unit 11 activates a subroutine for working condition estimation (step S511). The subroutine for working condition estimation is a subroutine for estimating a working condition threshold based on the steps described with reference to FIG. 11. After that, the control unit 11 ends the processing.

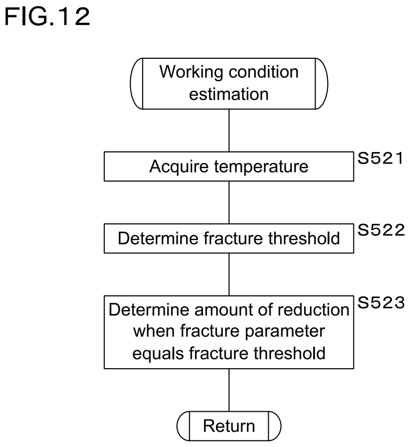

FIG. 12 is a flowchart illustrating a flow of the subroutine processing for working condition estimation. The control unit 11 acquires a target temperature at the completion of the hot working (S521). The control unit 11 determines a fracture threshold D_f corresponding to the temperature acquired at step S521 based on the simulation results of the plastic deformation described with reference to FIG. 9 (S522).

The control unit 11 determines an amount of reduction corresponding to the case where the fracture threshold D_f determined at step S522 is equal to the fracture parameter D, based on the simulation results of the hot working described with reference to FIG. 11 (step S523). The control unit 11 ends the processing.

According to the present embodiment, the working condition prediction system 20 for estimating a working condition under which no cracks occur in a material subjected to hot working can be achieved by the automatic processing or by the semi-automatic processing involving a professional technician who performs working of the test piece 45 and the hot working test of the test piece 45.

The automatic processing or the semi-automatic processing enables prediction of a working condition suitable for each production lot of steel ingots, which contributes to improvement in yield in the hot working process.

[Modification Example]

The modification example relates to the working condition prediction system 20 that implements hot working simulations at multiple reduction speeds. The parts that are common to those in Embodiment 2 will not be described.

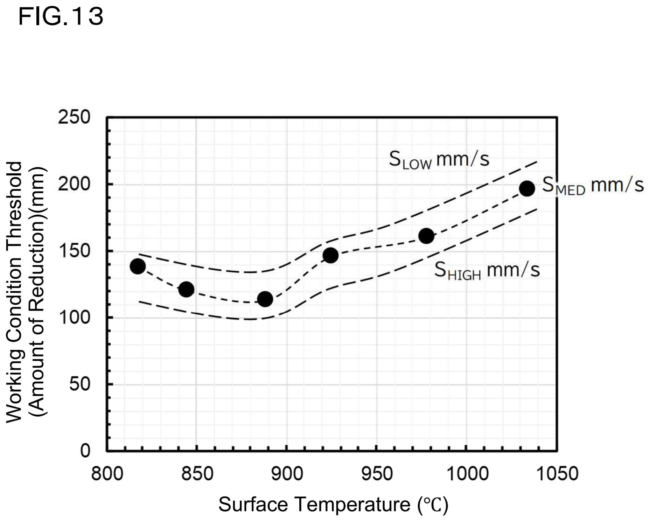

FIG. 13 illustrates a simulation result of hot working in the modification example. As in FIG. 6, the horizontal axis represents the surface temperature at the completion of hot working in units of degrees Celsius. The vertical axis represents the threshold for the working condition described with reference to FIG. 10.

The control unit 11 inputs multiple hot working conditions into the hot working simulation software 32 to calculate the relationship between the amount of reduction and the fracture parameter D described with reference to FIGs. 5 and 10. The control unit 11 calculates fracture thresholds D_f for the various temperatures T according to the procedure described in FIG. 10. FIG. 13 depicts graphs created under three conditions where the reduction speed is S LOW mm/s, S_MED mm/s and S_HIGH mm/s. Since graphs other than the graphs for S_MED mm/s are schematically depicted, plots indicating calculation locations are not displayed.

These graphs indicate low limits under which no cracks due to hot working occur. A case where the amount of reduction is 150 mm is described by way of example. In the case where the surface temperature of a material subjected to hot working is 930°C, the reduction speed at the lower limit under which no cracks occur is S_MED mm/s. That is, the threshold of the reduction speed when the amount of reduction is 150 mm is S MED mm/s.

The control unit 11 displays the graph in FIG. 13 on the display unit 15 to thereby offer data allowing the user to appropriately select the working conditions.

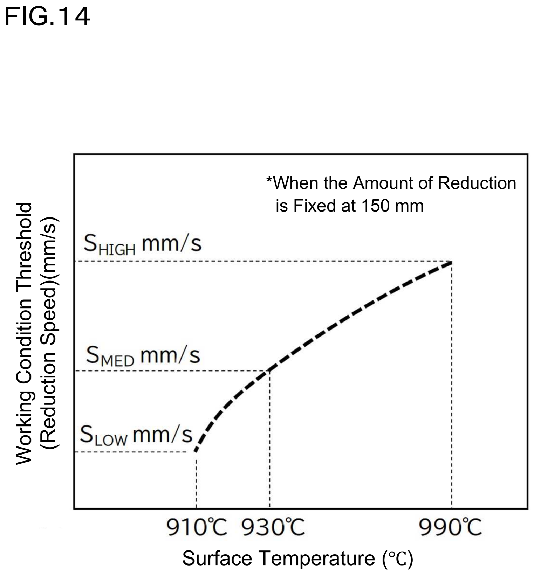

FIG. 14 is an example of a graph plotting data extracted when the amount of reduction is 150 mm from FIG. 13. Since the graph in FIG. 14 is a schematic graph, plots indicating calculation locations are not displayed. The horizontal axis in FIG. 14 represents the surface temperature at the completion of hot working in units of degrees Celsius. The vertical axis represents a threshold for the working condition represented by the reduction speed.

The control unit 11 plots the surface temperatures for the three graphs where the amount of reduction is 150 mm in FIG. 13 on the horizontal axis against the reduction speed on the vertical axis. The control unit 11 displays the graph in FIG. 14 on the display unit 15. This allows the user to promptly grasp the relationship between the surface temperature of the material subjected to hot working and the threshold of the reduction speed if the amount of reduction is fixed at 150 mm.

The vertical axis and the horizontal axis described above are both mere examples. In response to a change instruction for the vertical axis and the horizontal axis from the user, the control unit 11 can preferably display a corresponding graph.

The program is a mere example of the program product.

The computer program can be deployed on a single computer or one site, or can be dispersed on multiple sites and developed to be executable by multiple computers connected each other through the communication network.

The technical features (constituent features) in the embodiments can be combined with each other, and the combination can form a new technical feature.

It is to be understood that the embodiments disclosed here are illustrative in all respects and not restrictive. The scope of the present invention is defined by the appended claims, and all changes that fall within the meanings and the bounds of the claims, or equivalence of such meanings and bounds are intended to be embraced by the claims.

Independent claims and dependent claims stated in the scope of claims can be combined with each other in any combination, regardless of the citation format. In addition, the scope of claims uses the form of describing claims that depend from two or more other claims (multi-claim format), though not limited to this form. The scope of claims may also be described using multiple claims that depend from at least one multiple claims (multi-multi claims).

Reference Signs List

10    information processing apparatus
11    control unit
12    main storage
13    auxiliary storage
14    communication unit
15    display unit
16    input unit
19    reading unit
20    working condition prediction system
25    test piece working machine
26    hot working test machine
31    plastic deformation simulation software
32    hot working simulation software
40    sample
41    two-phase region test piece
42    non-decarburization layer test piece
45    test piece
96    portable recording medium
97    program
98    semiconductor memory

**Claims**

1. A prediction method for a hot working condition for predicting a hot working condition of a material subjected to hot working having a decarburization layer on a surface layer, comprising:

   a hot working property acquisition process of acquiring a hot working property at a part of a two-phase region of ferrite + austenite in the decarburization layer formed on the surface layer of the material subjected to hot working;
   a first analysis process of performing a plastic deformation analysis by simulation using the acquired hot working property as an input value and deriving a fracture threshold;
   a second analysis process of performing a plastic working analysis by simulation simulating actual hot working and deriving a fracture parameter corresponding to an amount of deformation of a material subjected to hot working; and
   a working condition derivation process of deriving a working condition threshold at a time of performing hot working in an actual machine based on the fracture threshold and the fracture parameter.

2. The prediction method for a hot working condition according to claim 1, further comprising:

   a process of producing a plurality of two-phase region test pieces from the part of the two-phase region, wherein the hot working property is acquired by a hot working test using the two-phase region test pieces.

3. The prediction method for a hot working condition according to claim 2, wherein the hot working property is acquired for each combination of one test temperature selected from a plurality of test temperatures and one strain rate selected from a plurality of strain rates.

4.  The prediction method for a hot working condition according to claim 1, further comprising:

a process of producing a plurality of two-phase region test pieces from the part of the two-phase region;
a process of producing a plurality of non-decarburization layer test pieces from a non-decarburization layer located deeper than the decarburization layer;
a process of implementing a hot working test on the two-phase region test pieces for each combination of one test temperature selected from a plurality of test temperatures and one strain rate selected from a plurality of strain rates; and
a process of implementing a hot working test on each of the non-decarburization layer test pieces for each combination of one test temperature selected from a plurality of test temperatures and one strain rate selected from a plurality of strain rates, wherein
the simulation for performing the plastic working analysis uses, as input data, data obtained from hot working tests of the two-phase region test pieces and hot working tests of the non-decarburization layer test pieces.

5.  A program causing a computer to execute processing of:

acquiring a hot working property at a part of a two-phase region of ferrite + austenite of a decarburization layer formed on a surface layer of $\alpha$ material subjected to hot working;
deriving a fracture threshold by performing a plastic deformation analysis by simulation using the acquired hot working property as an input value;
deriving a fracture parameter corresponding to an amount of deformation of a material subjected to hot working by performing a plastic working analysis by simulation simulating actual hot working; and
deriving a working condition threshold at a time of performing hot working in an actual machine based on the fracture threshold and the fracture parameter.

FIG.1

## FIG.2

```
                                    ┌──────────┐
                                    │  Start   │
                                    └──────────┘
┌─────────────────────┐                  │
│ Hot Working Property│                  │
│ Acquisition Process │                  ▼
└─────────────────────┘   ┌──────────────────────────────────────┐
                          │ Acquire hot working property at α+γ   │
                          │ two-phase region in a decarburization │
                          │ layer                                 │
                          └──────────────────────────────────────┘
┌─────────────────────┐                  │
│ First Analysis      │                  │
│ Process             │                  ▼
└─────────────────────┘   ┌──────────────────────────────────────┐
                          │ Specify relationship between fracture │
                          │ threshold inherent in material and    │
                          │ temperature by plastic deformation    │
                          │ simulation                            │
                          └──────────────────────────────────────┘
┌─────────────────────┐                  │
│ Second Analysis     │                  │
│ Process             │                  ▼
└─────────────────────┘   ┌──────────────────────────────────────┐
                          │ Calculate fracture parameter for      │
                          │ arbitrary hot working condition by    │
                          │ forging simulation                    │
                          └──────────────────────────────────────┘
┌─────────────────────┐                  │
│ Working Condition   │                  │
│ Derivation Process  │                  ▼
└─────────────────────┘   ┌──────────────────────────────────────┐
                          │ Comparing fracture parameter with     │
                          │ fracture threshold and specify hot    │
                          │ working condition that can suppress   │
                          │ forging cracks                        │
                          └──────────────────────────────────────┘
                                          │
                                          ▼
                                    ┌──────────┐
                                    │   End    │
                                    └──────────┘
```

FIG.3

31.0mm

2.7mm

2.7mm

15~20mm

Heating Region

## FIG.4

FIG.5

FIG.6

## FIG.7

## FIG.8

40

41
42
45

FIG.9

FIG.10

FIG.11

```
                    ( Start )
                        |
          +-------------------------+  S501
          |    Produce test pieces  |
          +-------------------------+
                        |
                        |<--------------------------------+
                        |                                 |
          +-------------------------+  S502               |
          |     Hot working test    |                     |
          +-------------------------+                      |
                        |                                  |
                 S503   |                                  |
                /\------+------/\   NO                     |
               /  Finish?       \--------+                 |
               \                /        |                 |
                \------+-------/         |                 |
                    YES|        +--------------------+ S504|
                 S505  |        | Change strain rate |     |
                /\-----+---/\   +--------------------+     |
               /  Finish?   \   NO                         |
               \            /----------+                   |
                \----+-----/           |                   |
                 YES |       +----------------------+ S506 |
                     |       | Change temperature   |------+
          +-------------------------+  S507
          | Measure thermophysical  |
          |        property         |
          +-------------------------+
                        |
          +-------------------------+  S508
          |   Plastic deformation   |
          |       simulation        |
          +-------------------------+
                        |
          +-------------------------+  S509
          | Calculate fracture threshold |
          +-------------------------+
                        |
          +-------------------------+  S510
          |   Hot working simulation |
          +-------------------------+
                        |
          +-------------------------+  S511
          ||   Working condition    ||
          ||      estimation        ||
          +-------------------------+
                        |
                    (  End  )
```

# FIG.12

```
   ┌─────────────────────┐
   │  Working condition  │
   │     estimation      │
   └─────────────────────┘
             │
   ┌─────────────────────┐
   │ Acquire temperature │  S521
   └─────────────────────┘
             │
   ┌─────────────────────────┐
   │ Determine fracture threshold │  S522
   └─────────────────────────┘
             │
   ┌────────────────────────────┐
   │ Determine amount of reduction │  S523
   │    when fracture parameter    │
   │    equals fracture threshold  │
   └────────────────────────────┘
             │
   ┌─────────────┐
   │   Return    │
   └─────────────┘
```

FIG.13

FIG.14

## INTERNATIONAL SEARCH REPORT

| | International application No. |
|---|---|
| | **PCT/JP2024/012881** |

| A. | CLASSIFICATION OF SUBJECT MATTER |
|---|---|

***B21J 5/00***(2006.01)i; ***B21B 1/22***(2006.01)i; ***B21B 3/00***(2006.01)i; ***B21B 37/00***(2006.01)i
FI:     B21J5/00 Z; B21B3/00 A; B21B1/22 M; B21B37/00 300

According to International Patent Classification (IPC) or to both national classification and IPC

| B. | FIELDS SEARCHED |
|---|---|

Minimum documentation searched (classification system followed by classification symbols)

B21J5/00; B21B1/22; B21B3/00; B21B37/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | JP 4559256 B2 (KABUSHIKI KAISHA KOBE SEIKO SHO (KOBE STEEL, LTD.)) 06 October 2010 (2010-10-06) | 1-5 |
| A | JP 7197037 B2 (JFE STEEL CORP.) 27 December 2022 (2022-12-27) | 1-5 |
| A | JP 7056592 B2 (JFE STEEL CORP.) 19 April 2022 (2022-04-19) | 1-5 |
| A | JP 2001-349883 A (HITACHI METALS, LTD.) 21 December 2001 (2001-12-21) | 1-5 |
| A | WO 2013/128646 A1 (TOHOKU UNIVERSITY) 06 September 2013 (2013-09-06) | 1-5 |

☐ Further documents are listed in the continuation of Box C.      ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **10 April 2024** | **21 May 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

## INTERNATIONAL SEARCH REPORT
### Information on patent family members

International application No.

**PCT/JP2024/012881**

| Patent document cited in search report | | | Publication date (day/month/year) | Patent family member(s) | | | Publication date (day/month/year) |
|---|---|---|---|---|---|---|---|
| JP | 4559256 | B2 | 06 October 2010 | (Family: none) | | | |
| JP | 7197037 | B2 | 27 December 2022 | US | 2022/0072593 | A1 | |
| | | | | WO | 2020/148917 | A1 | |
| | | | | EP | 3912740 | A1 | |
| JP | 7056592 | B2 | 19 April 2022 | US | 2022/0072593 | A1 | |
| | | | | WO | 2020/148917 | A1 | |
| | | | | EP | 3912740 | A1 | |
| | | | | CN | 113272079 | A | |
| | | | | KR | 10-2021-0110368 | A | |
| JP | 2001-349883 | A | 21 December 2001 | (Family: none) | | | |
| WO | 2013/128646 | A1 | 06 September 2013 | (Family: none) | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010131621 A

- JP 2022041548 A